# EUROPEAN PATENT SPECIFICATION

(11) **EP 1 024 369 B1**
(45) Date of publication and mention of the grant of the patent: **20.10.2004**
(21) Application number: 99830030.5
(22) Date of filing: 26.01.1999
(51) Int. Cl.: G01R 31/26

(54) **Characterization of a semiconductor-dielectric interface by photocurrent measurements**
Charakterisierung einer Halbleiter-Dielektrikum-Grenzschicht mittels Photostrom-Messungen
Caractérisation d'une interface semi-conducteur-diélectrique par mesure de photocourants

(43) Date of publication of application: 02.08.2000
(73) Proprietor: STMicroelectronics S.r.l., 20041 Agrate Brianza (Milano) (IT)
(72) Inventor: Polignano, Maria Luisa, 20040 Cambiago (IT); Caricato, Anna Paola, 73100 Lecce (IT); Caputo, Daniele, 20126 Milano (IT)
(74) Representative: Pellegri, Alberto

(56) References cited:
- US-A- 4 420 497
- US-A- 4 433 288
- US-A- 5 130 643
- V. LEHMANN ET AL.: "Minority carrier diffusion length mapping in silicon wafers using a Si-electrolyte-contact" JOURNAL OF THE ELECTROCHEMICAL SOCIETY., vol. 135, no. 11, November 1988, pages 2831-2835, XP002107593 MANCHESTER, NEW HAMPSHIRE US

## Description

The present invention relates in general to characterization and mapping techniques of a semiconductor substrate by way of measurements of photocurrents stimulated by scanning the surface of the semiconductor with a laser beam, collected through contacts established through an electrolytic solution.

More in particular, the invention relates to characterization techniques of an interface between a semiconductor substrate and a thermally grown or deposited dielectric layer.

Photocurrent measurements using an electrolyte in contact with the surface of the semiconductor and in which is immersed an electrode of a nonpassivating noble metal such as platinum to establish electrical connection to a biasing circuit, are notably used to measure the meanlife of bulk minority carriers of a semiconductor silicon wafer ^{[1]}.
^{[1]} V. Lehmann and H. Foll, J. Electrochem. Soc. 135, 2831 (1988).

According to this technique, excess carriers are injected by means of a laser beam on the wafer's frontsurface and collected through an inversely biased Schottky contact, realized or on the wafer's backsurface (backside photocurrent mode) or on the same wafer's frontsurface (frontside photocurrent mode).

Often, when operating in a backside photocurrent mode by collecting the photocurrent at the wafer's backsurface, an area of the wafer's front is immersed or contacted with a solution suitable to passivate the superficial layers of the wafer and the Schottky contact is biased through a contact established on the wafer's backsurface using an electrolyte with a nonpassivating electrode of a noble metal such as platinum immersed in the electrolytic solution.

The Schottky contact must be inversely biased in respect to the bulk potential of the wafer which is grounded through one or more ohmic contacts realized on the silicon around the contacted areas or through the electric charges collecting electrolytic solution and eventually through the passivating solution.

In commercially available instrumentation such as for example the "Electrolytic Metal Tracer (Elymat)" of GeMeTec GmbH, both the passivating solution and the electrolytic solution employed to realize the Schottky contact for collecting photocurrents consists of a diluted fluoridric acid HF solution. Any native or thermal oxide film that may be present on the surface of the semiconductor wafer, is etched away by the HF solution, which also ensures an optimal surface passivation of the silicon ^{[2]}.
^{[2]} E.Yablonovitch, D. L. Allara, C. C. Chang, T. Gmitter and T. B. Bright, Phys. Rev. Letters 57, 249 (1986).

According to needs, the current may be collected on either the wafer's backside or frontside ^{[3]} through electrodes of a nonpassivating noble metal, typically of platinum, functionally immersed in the electrolytic solution.
^{[3]} H. Foll, Symp. on Advanced Science Technol and of Silicon Mat, Kona, Hawaii, 1991.

The light source for stimulating the photocurrent is a laser beam focused on the wafer's surface (eventually through the film of passivating HF solution) and scanning it by successive lines in order to produce maps of bulk carriers meanlife.

The US Patent No. 5,130,643 discloses a two-stage method for determining the recombination speed of minority carriers at boundary surfaces between semiconductors and other substances.

The US Patent No. 4,420,497 discloses a method of detecting and repairing latent defects in a dielectric layer on a semiconductor substrate on which a circuit is to be formed. The defects are damaged by the application of an electric field, and are repaired by the selective oxidation or nitridation of the silicon substrate underlying the damaged areas.

The US Patent No. 4,433,288 provides a method and apparatus for determining the diffusion length of minority carriers in semiconductor materials, using the constant magnitude surface-photovoltage (SPV) method.

Lately, proposals have been made for modifying this measuring technique to adapt it for the an evaluation of the surface recombination velocity at the interface between a semiconductor substrate typically silicon and a dielectric layer, for example a thermally grown silicon oxide (a gate oxide or a tunnel oxide) ^{[4]} ^{[5]}.
^{[4]} M. L. Polignano, G. Ferroni, A. Sabbadini, G. Valentini and G. Queirolo, Journal of Solids non-Crystalline 216, 88, (1997).
^{[5]} H. C. Ostendorf and A. L. Endors, in "Defects and Impurity Engineered Semiconductors Devices and", S. Ashok, J. Chevalier, The Akasaki, N. M. Johnson and B. L. Sapori, eds, PV 378, p. 579, The Material Research Society Symposium Proceedings, Pittsburgh, PA, (1995).

According to these modifications, the laser beam scans the surface of the dielectric layer that covers the semiconductor substrate, in absence of a film of a passivating acid solution because if present it would etch the dielectric oxide and would destroy the interface being examined.

In these conditions, the photocurrent collected through the Schottky contact that is preferably established on the backside of the wafer of semiconducting silicon through an electrolyte, depends on the bulk minority carriers meanlife as well as on the surface recombination velocity at the semiconductor-dielectric interface, and both parameters may be assessed from a sequence of measurements carried out at different conditions.

The surface recombination velocity is a parameter that may be extremely useful for characterizing semiconductor-dielectric interfaces, for example an oxide/silicon interface of a gate oxide or tunnel oxide.

The extension of photocurrent measuring techniques to the characterization of semiconductor-dielectric interfaces is of great interest because these measurement techniques, as compared to others, require a minimum sample preparation, and are able to generate detailed maps of the entire wafer's surface.

Although of great interest, this technique has serious limitations. Indeed, the surface recombination is strongly influenced by the density of the superficial layers and by the surface potential.

It has been demonstrated ^{[6]} that the surface recombination velocity may dramatically vary upon the varying of the surface potential: from a condition of accumulation of majority carriers in respect to the bulk density to a condition of inversion, that is wherein in the silicon at the interface there is a concentration of minority carriers comparable to the concentration of majority carriers in the bulk, as it may occur in presence of electric charges in the oxide at the interface.
^{[6]} A. G. Aberle, S. Glunz. W. Warta, J. Appl. Phys. 71, 4422, 1992.

However, according to the present techniques, the surface potential cannot be controlled and effects due to the superficial layer density and to eventual electric charges in the oxide cannot be distinguished.

Vis-à-vis with these shortcomings of the present techniques, it has now been found an effective manner to overcome these limitations by substantially realizing a "gate" electrode in the form of a layer of electrolyte in contact with the dielectric layer and biased through an electrode immersed in it. This is made possible by using an electrolyte that is not aggressive of the dielectric oxide. It has been found that a solution of an organic acid, such as for example an acetic acid solution, biased with a platinum electrode, is perfectly suitable to realize an effective gate electrode coupled to the silicon oxide dielectric, and through which it is possible to control the surface potential at the dielectric-semiconductor interface.

The possibility to control the potential at the dielectric-semiconductor interface by suitably biasing the gate electrode constituted by the electrolyte, in respect to the semiconductor substrate potential, permits to assess the surface recombination velocity at the interface in function of the voltage applied to the gate electrode besides a charge injection level established by controlling the scanning laser beam. The analysis of these data permits to determine both the density of surface states and the electric charges in the dielectric.

An analytical approach similar to the one described in ^{[6]} may be utilized for a quick evaluation. A more accurate analysis may be carried out by the use of a numerical processor of device equations, for example continuity and drift-diffusion equations.
^{[6]} A. G. Aberle, S. Glunz. W. Warta, J. Appl. Phys. 71, 4422, 1992.

Compared to the known methods of measuring the surface recombination velocity, the novel method of the invention has the advantage of discriminating between the effects caused by density of surface states and by eventual electric charges in the dielectric, thus providing an information comparable to that obtained through capacitance-voltage measurements.

Compared to traditional characterization methods based on capacitance-voltage measurements, a method based on surface recombination measurements has the advantage of not requiring the realization of capacitors and therefore permits a faster quality control checks of the dielectric/semiconductor interface.

Moreover, the wafers may be more accurately mapped through a surface recombination measurements than through capacitance-voltage measurements and an accurate map of the entire wafer may often reveal the reasons for an observed interface degradation.

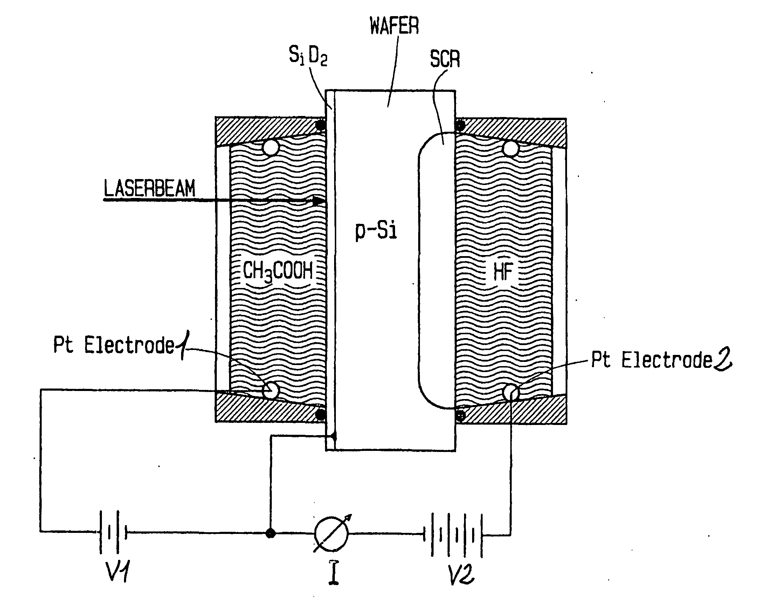

The attached figure shows a sectional view of the measurement instrumentation according to the present invention.

The Schottky contact that collects the photocurrent is realized on the backside of the wafer by biasing the electrolytic HF solution with a platinum electrode Pt ELECTRODE 2 in relation to the potential of the wafer, that is contacted through one or more ohmic contacts, that may be established on the frontside (as schematically shown in the figure) or on the backside of the wafer, preferably around the Schottky contact area.

According to the invention, on the dielectric layer of Si0₂ present on the frontside is established a gate electrode, an acetic acid solution, biased with a platinum electrode Pt ELECTRODE 1 immersed therein, in relation to the potential of the wafer.

The electrolytic solution that constitutes the gate electrode on the dielectric may be suitable confined by any of the conventionally used arrangements in this type of instruments and the container of the electrolytic solution has a transparent cover or wall through which and through the thickness of the electrolytic film itself, the laser beam illuminates the wafer covered by the dielectric layer in order to inject excess carriers that are eventually collected through the Schottky contact, through the spatial charge region (SCR) of the Schottky junction realized on the backside of the wafer.

The inverse biasing voltage V2 of the Schottky contact, established on the backside of the silicon wafer, should be sufficiently high to guarantee that according to the inverse I-V characteristic of the junction, the latter be in a saturation condition (to protect from the effects of series resistances) and not excessively high such that the collected current be greater or at least of the same order of magnitude of the junction dark current. Typically, for a silicon wafer of p-type conductivity and 10Ωcm resistivity, the bias voltage may be comprised between -5V and -10V (inverse bias).

The gate electrode constituted by the acetic acid electrolytic solution in contact with the dielectric layer of silicon oxide on the frontside is biased such to move shift from a condition of accumulation to an inversion condition. The voltage V1 should not reach values as high as to provoke a significant current leakage through the dielectric, compared to the diffusion current collected by way of the Schottky contact at the backside of the wafer. For relatively thin oxides with a thickness of about 100Å, preliminary tests have demonstrated that gate voltages ranging within about ±1.5 V are adequate and produce a negligible current leakage. Of course, thicker oxides would require proportionally increased voltages.

## Claims

1. A method for characterizing a semiconductor/substrate/dielectric layer interface through measurements of a photocurrent induced in the semiconductor by scanning a certain area of the interface with a laser beam and collected by way of a Schottky contact established by inversely biasing in respect to the potential of the bulk of the semiconductor substrate an electrolyte capable of etching any native or thermal oxide that may exist on the contact area with the semiconductor substrate, **characterized in that** the surface potential of the semiconductor/dielectric interface is controlled by means of a gate electrode established on the dielectric layer by way of a second electrolyte not aggressive of the dielectric material and biased by an electrode (Pt ELECTRODE 1) immersed in said second electrolyte in respect to the potential of the bulk of said semiconductor substrate.

2. The method according to claim 1, **characterized in that** said first electrolyte (HF) used to constitute a Schottky contact on a certain area of the semiconductor substrate is a diluted HF solution biased by a platinum electrode (Pt ELECTRODE 2) immersed in the electrolyte and said second electrolyte not aggressive of the dielectric material constituting said gate electrode is an acetic acid solution and the biasing electrode immersed in it is of platinum.

3. An instrument for measuring a photocurrent collected through a Schottky contact established by inversely biasing an electrolyte in contact with the semiconductor substrate, capable to etch any native or thermal oxide existing on the contact area, in respect to the substrate potential, stimulated by scanning a certain surface of the substrate coated with a dielectric layer with a laser beam, for performing characterization measurements of the semiconductor/dielectric layer interface, **characterized in that** it comprises means implementing a biasable gate electrode on the dielectric on the area scanned by said laser beam in the form of a transparent layer of electrolyte not aggressive of the dielectric material and an electrode (Pt ELECTRODE 1) of a nonpassivatable metal immersed in said electrolyte.

4. The instrument according to claim 3, **characterized in that** said nonaggressive electrolyte is an acetic acid solution and said metal electrode (Pt ELECTRODE 1) immersed therein is of platinum.

## Patentansprüche

1. Verfahren zum Charakterisieren einer Grenzfläche Halbleiter/Substrat/dielektrische Schicht durch Messungen eines Photostroms, der im Halbleiter durch Abtastung eines bestimmten Bereichs der Grenzfläche mit einem Laserstrahl induziert wird und durch einen Schottky-Kontakt gesammelt wird, der hergestellt wird, indem bezüglich des Potentials der Hauptmasse des Halbleitersubstrats ein Elektrolyt umgekehrt vorgespannt wird, das imstande ist, jedes natürliche oder thermische Oxid zu ätzen, das auf der Kontaktfläche mit dem Halbleitersubstrat vorhanden sein kann, **dadurch gekennzeichnet, daß** das Oberflächenpotential der Grenzfläche Halbleiter/Dielektrikum mittels einer Gate-Elektrode gesteuert wird, die auf der dielektrischen Schicht durch ein zweites Elektrolyt hergestellt wird, das für das dielektrische Material nicht aggressiv ist und durch eine Elektrode (ELECTRODE1), die in das zweite Elektrolyt eingetaucht ist, bezüglich des Potentials der Hauptmasse des Halbleitersubstrats vorgespannt wird.

2. Verfahren nach Anspruch 1, **dadurch gekennzeichnet, daß** das erste Elektrolyt (HF), das verwendet wird, um einen Schottky-Kontakt auf einem bestimmten Bereich des Halbleitersubstrats zu bilden, eine verdünnte HF-Lösung ist, die durch eine Platinelektrode (Pt ELECTRODE2) vorgespannt wird, die in das Elektrolyt eingetaucht wird, und das zweite Elektrolyt, das für das dielektrische Material nicht aggressiv ist, das die Gate-Elektrode bildet, eine Essigsäurelösung ist, und die Vorspannelektrode, die in sie eingetaucht ist, aus Platin besteht.

3. Instrument zur Messung eines Photostroms, der durch einen Schottky-Kontakt gesammelt wird, der hergestellt wird, indem ein Elektrolyt, das in Kontakt mit dem Halbleitersubstrat steht, das imstande ist, jedes natürliche oder thermische Oxid zu ätzen, das auf der Kontaktfläche vorkommt, bezüglich des Substratpotentials umgekehrt vorgespannt wird, der durch Abtastung einer bestimmten Oberfläche des Substrats, die mit einer dielektrischen Schicht überzogen ist, mit einem Laserstrahl stimuliert wird, zur Durchführung von Charakterisierungsmessungen der Grenzfläche Halbleiter/dielektrische Schicht, **dadurch gekennzeichnet, daß** es eine Einrichtung aufweist, die eine vorspannbare Gate-Elektrode auf dem Dielektrikum auf dem Bereich, der durch den Laserstrahl abgetastet wird, in der Form einer transparenten Schicht eines Elektrolyts implementiert, das für das dielektrische Material nicht aggressiv ist und eine Elektrode (ELECTRODE1) aus einem nichtpassivierbaren Metall, die in das Elektrolyt eingetaucht ist.

4. Instrument nach Anspruch 3, **dadurch gekennzeichnet, daß** das nichtaggressive Elektrolyt eine Essigsäurelösung ist und die darin eingetauchte Metallelektrode (Pt ELECTRODE1) aus Platin besteht.

## Revendications

1. Procédé de caractérisation de l'interface entre un substrat semiconducteur et une couche diélectrique par des mesures du photocourant induit dans le semiconducteur en balayant une certaine zone de l'interface par un faisceau laser et recueilli par un contact Schottky établi en polarisant en inverse par rapport au potentiel du corps du substrat semiconducteur un électrolyte apte à graver de l'oxyde natif ou thermique qui peut exister sur la zone de contact avec le substrat semiconducteur, **caractérisé en ce que** le potentiel de surface de l'interface entre le semiconducteur et le diélectrique est commandé par une électrode de grille établie sur la couche diélectrique par un second électrolyte non agressif pour le matériau diélectrique et polarisé par une électrode (ELECTRODE 1) immergé dans le second électrolyte par rapport au potentiel du corps du substrat semiconducteur.

2. Procédé selon la revendication 1, **caractérisé en ce que** le premier électrolyte (HF) utilisé pour constituer un contact Schottky sur une certaine zone du substrat semiconducteur est une solution de HF dilué polarisée par une électrode de platine (ELECTRODE 2) immergée dans l'électrolyte et le second électrolyte non agressif pour le matériau diélectrique constituant l'électrode de grille est une solution d'acide acétique, et l'électrode de polarisation qui y est immergée est en platine.

3. Appareil de mesure du photocourant recueilli par un contact Schottky établi en polarisant en inverse un électrolyte en contact avec le substrat semiconducteur, apte à graver un oxyde natif ou thermique existant sur la zone de contact, par rapport au potentiel du substrat, stimulé par balayage d'une certaine surface du substrat revêtu d'une couche diélectrique par un faisceau laser, pour réaliser des mesures de caractérisation de l'interface entre le semiconducteur et la couche diélectrique, **caractérisé en ce qu'**il comprend des moyens mis en oeuvre par une électrode de grille polarisable sur le diélectrique sur la zone balayée par le faisceau laser sous forme d'une couche transparente d'un électrolyte non agressif pour le matériau diélectrique et d'une électrode (ELECTRODE 1) d'un matériau non passivable immergé dans l'électrolyte.

4. Appareil selon la revendication 3, **caractérisé en ce que** l'électrolyte non agressif est une solution d'acide acétique et l'électrode métallique (ELECTRODE 1) qui y est immergée est en platine.
